# EUROPEAN PATENT SPECIFICATION

(11) **EP 4 006 956 B1**
(45) Date of publication and mention of the grant of the patent: **10.06.2026**
(21) Application number: 19938181.5
(22) Date of filing: 25.07.2019
(51) Int. Cl.: H10P 72/30, H10P 72/76

(54) **PROCESS CHAMBER OF EPITAXIAL GROWTH APPARATUS**
PROZESSKAMMER EINER EPITAKTISCHEN WACHSTUMSVORRICHTUNG
CHAMBRE DE TRAITEMENT D'APPAREIL DE CROISSANCE ÉPITAXIQUE

(43) Date of publication of application: 01.06.2022
(73) Proprietor: Epicrew Corporation, Ohmura-shi, Nagasaki 856-0022 (JP)
(72) Inventor: OKABE, Akira, Ohmura-shi, Nagasaki 856-0022 (JP); TAKENAGA, Yukio, Ohmura-shi, Nagasaki 856-0022 (JP)
(74) Representative: AWA Sweden AB
(86) International application number: PCT/JP2019/029303
(87) International publication number: WO 2021/014657

(56) References cited:
- WO-A1-2019/004201
- JP-A- 2001 024 047
- JP-A- 2001 024 047
- JP-A- 2002 231 794
- JP-A- 2003 124 287
- JP-A- 2007 123 810
- JP-A- 2009 246 229
- US-A- 6 120 609
- US-A1- 2004 177 813
- US-A1- 2006 005 770
- US-A1- 2014 007 808

## Description

### [Technical Field]

The present invention relates to a process chamber of an epitaxial growth apparatus.

### [Background Art]

In the related art, in a semiconductor manufacturing apparatus, a process chamber in which a film is formed on a semiconductor substrate through, for example, heat treatment is known.

As such a process chamber, the following patent document 1 discloses a configuration including a susceptor that can be raised to take out a semiconductor substrate.

US 2014/0007808 A1 discloses a susceptor device and deposition apparatus having a susceptor device.

### [Citation List]

### [Patent Document]

[Patent Document 1]
Japanese Unexamined Patent Application Publication No. 2014-222693

### [Summary of Invention]

### [Technical Problem]

However, in the invention disclosed in patent document 1, since a susceptor is lifted, there is a problem that the whole process chamber is bulky in an upward/downward direction.

Here, the present invention is directed to providing a process chamber of an epitaxial growth apparatus capable of minimizing bulkiness in the upward/downward direction.

### [Solution to Problem]

In order to solve the aforementioned problems, a process chamber of an epitaxial growth apparatus of the present invention is directed to a process chamber configured to perform reaction processing on a semiconductor substrate, which includes a susceptor supported and disposed in the process chamber by a shaft member supporting only a central portion in a radial direction and extending in an upward/downward direction, and on which the semiconductor substrate is placed, a finger plate wafer lift disposed below the susceptor and configured to be movable in an axial direction of the shaft member, and a lift pin configured to displace the semiconductor substrate upward from an upper surface of the susceptor according to approach of the finger plate wafer lift to the susceptor, and a through-hole through which the lift pin passes is formed in the susceptor.

The finger plate wafer lift includes: a support pipe extending in the upward/downward direction; and a plurality of support arms extending from an upper end portion of the support pipe in the radial direction, a tip portion facing the lift pin in the upward/downward direction is formed on an outer end portion of the support arm in the radial direction, and the tip portion has a size that is greater than that of a portion of the support arm in a circumferential direction except the tip portion.

In addition, the semiconductor substrate may be placed on a portion of the upper surface of the susceptor except the outer circumferential edge portion, a placing surface recessed more than the outer circumferential edge portion may be formed thereon, and the through-hole may be formed in an outer end portion of the placing surface in the radial direction.

### [Advantageous Effects of the Invention]

According to a process chamber of an epitaxial growth apparatus of the present invention, a susceptor, only a central portion in a radial direction of which is supported, is provided. In this case, a semiconductor substrate can be displaced upward by raising a lift pin passing through a through-hole of the susceptor.

For this reason, for example, in comparison with the configuration in which the susceptor is greatly raised and a semiconductor substrate is displaced upward, it is possible to reduce a configuration of a portion displaced in an upward/downward direction, and minimize bulkiness of the process chamber in the upward/downward direction.

### [Brief Description of the Drawings]

Fig. 1 is a longitudinal cross-sectional view of a semiconductor manufacturing apparatus including a process chamber of an epitaxial growth apparatus according to an embodiment of the present invention.
Fig. 2(a) is a perspective view showing a susceptor unit of the process chamber shown in Fig. 1, and Fig. 2(b) is a view showing the susceptor unit of Fig. 2(a), a susceptor of which is shown as being transparent.
Fig. 3(a) is a front view of the susceptor unit, and Fig. 3(b) is a plan view of a finger plate wafer lift.
Fig. 4 is a diagram illustrating a process of conveying a semiconductor substrate into the process chamber shown in Fig. 1.
Fig. 5 is a diagram illustrating a process of performing reaction processing of the semiconductor substrate in the process chamber shown in Fig. 1.
Fig. 6 is a diagram illustrating a process of taking the semiconductor substrate out of the process chamber shown in Fig. 1.

### [Description of Embodiments]

Next, a process chamber 2 of an epitaxial growth apparatus according to an embodiment of the present invention will be described with reference to the accompanying drawings.

The process chamber 2 according to the embodiment is directed to a chamber in which reaction processing is performed to form a film on a semiconductor substrate S through heat treatment, for example, in a semiconductor manufacturing apparatus 1. First, a configuration of the semiconductor manufacturing apparatus 1 will be described.

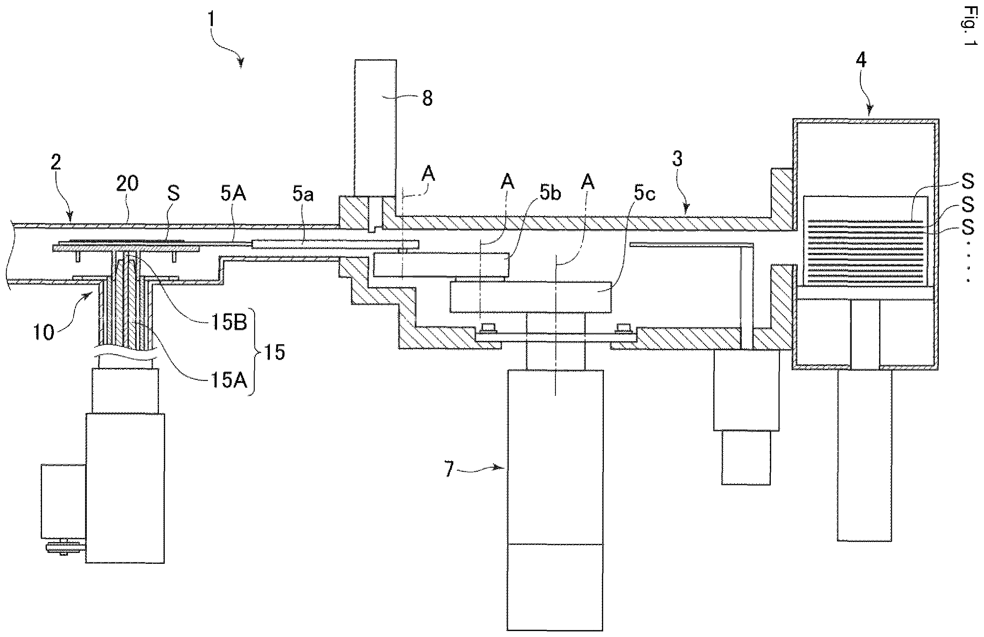

As shown in Fig. 1, the semiconductor manufacturing apparatus 1 includes the process chamber 2, a conveyance chamber 3 configured to convey the semiconductor substrate S into the process chamber 2, and a load lock chamber 4 connected to the conveyance chamber 3.

The conveyance chamber 3 is disposed between the process chamber 2 and the load lock chamber 4.

The conveyance chamber 3 includes a conveyance robot 7. The conveyance robot 7 includes three robot arms 5a, 5b and 5c. The robot arms 5a, 5b and 5c are disposed pivotably around a pivot shaft A. The robot arms 5a, 5b and 5c can be expanded and contracted in a horizontal direction by being pivoted around the pivot shaft A.

In the plurality of robot arms 5a, 5b and 5c, a blade 5A is provided on a tip of the robot arm 5a located at the uppermost side. In a state in which the semiconductor substrate S is placed on an upper surface of the blade 5A, the semiconductor substrate S can be conveyed by expanding and contracting the three robot arms 5a, 5b and 5c in a horizontal direction.

An L type gate valve 8 is disposed in a portion of the conveyance chamber 3 continuous with the process chamber 2. Accordingly, it is possible to securely guarantee airtightness between the process chamber 2 and the conveyance chamber 3.

In the load lock chamber 4, an airtight door is disposed in a portion of the load lock chamber 4 continuous with the conveyance chamber 3 in order to put the semiconductor substrate S in the conveyance chamber 3 and take it out. Accordingly, it is possible to securely guarantee airtightness between the load lock chamber 4 and the conveyance chamber 3.

The process chamber 2 includes a susceptor unit 10 on which the semiconductor substrate S is placed, and a chamber main body 20 in which the susceptor unit 10 is disposed.

A heat source (not shown) configured to heat the semiconductor substrate S is disposed above and below the chamber main body 20. While, for example, a halogen lamp may be employed as the heat source, it is not limited to this example.

Next, a configuration of the susceptor unit 10 will be described in detail.

The susceptor unit 10 includes a susceptor 11 on which the semiconductor substrate S is placed, a finger plate wafer lift 12 disposed below the susceptor 11, and a lift pin 13 configured to displace the semiconductor substrate S upward from the upper surface of the susceptor 11 according to approach of the finger plate wafer lift 12 to the susceptor 11.

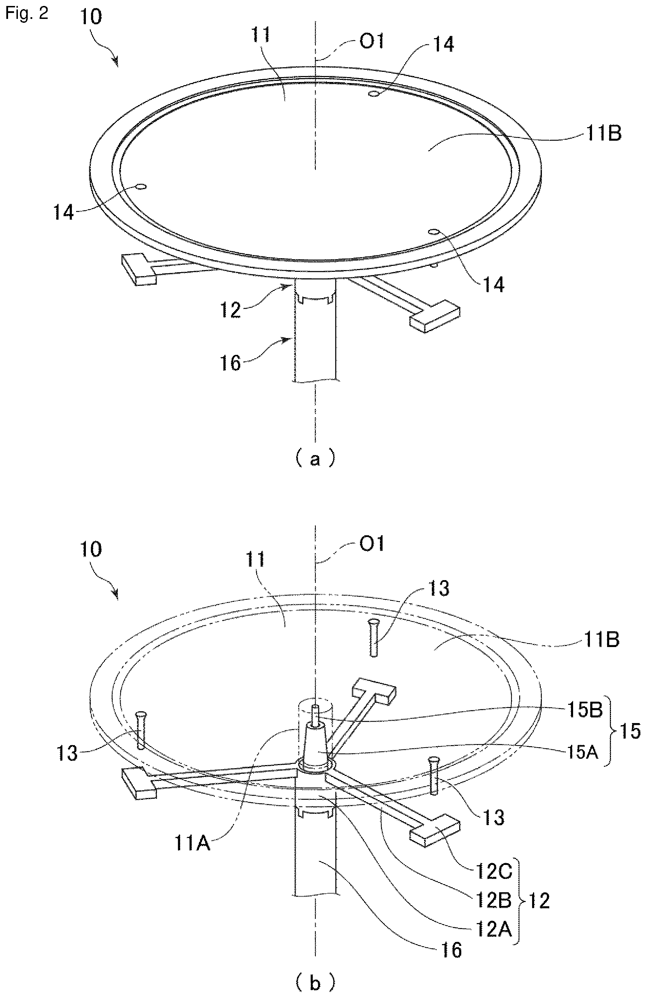

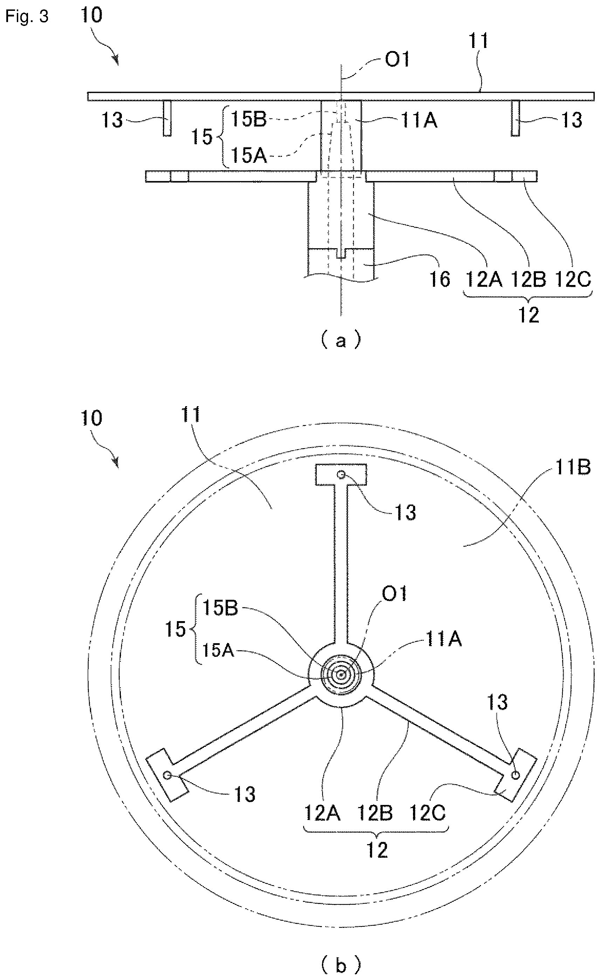

As shown in Figs. 2 and 3, the susceptor 11 is supported and disposed in the process chamber 2. The semiconductor substrate S is placed on the upper surface of the susceptor 11. Only a central portion of the susceptor 11 in a radial direction is supported by a susceptor shaft (a shaft member) 15 from below. The susceptor 11 has a circular plate shape when seen in a plan view.

In the following description, a straight line perpendicular to the susceptor 11 and passing through a center thereof is referred to as a central axis O1. In addition, a direction perpendicular to the central axis O1 is referred to as a radial direction, and a direction around the central axis O1 is referred to as a circumferential direction.

A fitting pipe 11A protruding downward and having a lower end portion that opens downward is formed on a central portion of a lower surface of the susceptor 11 in the radial direction. An upper end portion of the susceptor shaft 15 is fitted into the fitting pipe 11A.

The semiconductor substrate S is placed on a portion of the upper surface of the susceptor 11 except an outer circumferential edge portion, and a placing surface 11B recessed more than the outer circumferential edge portion is formed therein.

The susceptor 11 and the susceptor shaft 15 are configured rotatably in the circumferential direction. Through-holes 14 passing through the susceptor 11 in the upward/downward direction are formed in the susceptor 11. The through-holes 14 are formed in the outer end portion of the placing surface 11B of the susceptor 11 in the radial direction.

The plurality of through-holes 14 are disposed at intervals in the circumferential direction. In the example shown, three through-holes 14 are disposed at equal intervals in the circumferential direction. Inner diameters of the upper end portions of the through-holes 14 gradually increase upward. It is possible for such a shape to prevent the lift pin 13 from falling from the through-holes 14.

The susceptor shaft 15 extends in the upward/downward direction and is disposed coaxially with the central axis O1. As shown in Fig. 1, the susceptor shaft 15 is constituted by a shaft susceptor support 15A and a thermoelectric couple 15B.

The shaft susceptor support 15A has a tubular shape, and the thermoelectric couple 15B passes therethrough. The shaft susceptor support 15A and the thermoelectric couple 15B are disposed coaxially with the central axis O1.

The upper end portion of the shaft susceptor support 15A has a diameter that is gradually reduced upward. The thermoelectric couple 15B extends straight in the upward/downward direction.

A portion of the upper end portion of the shaft susceptor support 15A, a diameter of which is reduced, is fitted into the fitting pipe 11A of the susceptor 11. Positions of the susceptor 11 and the susceptor shaft 15 in the circumferential direction are fixed to each other.

The finger plate wafer lift 12 is configured to be movable in the axial direction of the susceptor shaft 15, and configured to be raised with respect to the susceptor 11 and the susceptor shaft 15. The finger plate wafer lift 12 is connected to a side above a shaft wafer lift 16 extending in the upward/downward direction.

The finger plate wafer lift 12 includes a support pipe 12A connected to an upper end portion of the shaft wafer lift 16 and extending in the upward/downward direction, and a plurality of support arms 12B extending from an upper end portion of the support pipe 12A in the radial direction.

The shaft wafer lift 16 and the support pipe 12A are formed separately from each other. In contrast, the shaft wafer lift 16 and the support pipe 12A may be formed integrally with each other. The support pipe 12A and the support arms 12B are formed integrally with each other. In contrast, the support pipe 12A and the support arms 12B may be formed separately from each other.

The shaft wafer lift 16 is disposed coaxially with the susceptor shaft 15. The susceptor shaft 15 is inserted into the shaft wafer lift 16. The shaft wafer lift 16 is configured to be relatively displaceable with respect to the susceptor shaft 15 in the upward/downward direction and the circumferential direction.

The support arms 12B radially extend outward from the upper end portion of the support pipe 12A in the radial direction. In the example shown, three support arms 12B are disposed at equal intervals of 120°. The support arms 12B extend straight in the horizontal direction.

A lift plate (a tip portion) 12C facing the lift pin 13 in the upward/downward direction is formed on an outer end portion of the support arms 12B in the radial direction. The lift plate 12C has a size in the circumferential direction that is greater than a portion of the support arms 12B except the lift plate 12C.

As shown in Fig. 3(b), the lift plate 12C has a rectangular shape, two sides of which extend in a tangential direction of an outer circumferential edge of the susceptor 11 and the remaining two sides of which extend in the radial direction when seen in a plan view. A size of the lift plate 12C in the circumferential direction is greater than a size in the radial direction.

When seen in a plan view, the lift pin 13 is located at a central portion of the lift plate 12C in the circumferential direction and the radial direction.

The lift pin 13 is lifted to the lift plate 12C of the finger plate wafer lift 12 according to rising of the finger plate wafer lift 12.

The lift pin 13 is inserted into the through-holes 14 and passes through the through-holes 14 according to the rising movement. The lift pin 13 is disposed in each of the three through-holes 14. The lift pin 13 is located at a position that does not interfere with the blade 5A of the robot arm 5a.

An outer diameter of the upper end portion of the lift pin 13 gradually increases upward. Further, the upper end portion of the lift pin 13 is engaged with the upper end portion of the through-hole 14 in the upward/downward direction, and thus the lift pin 13 is held on the inner surface of the through-hole 14.

The lower end portion of the lift pin 13 protrudes downward from the susceptor 11 while being held on the inner surface of the through-hole 14. In this state, the upper end surface of the lift pin 13 that is directed upward is flush with the upper surface of the susceptor 11.

The lift pin 13 is formed on the outer end portion of the placing surface 11B of the susceptor 11 in the radial direction when seen in a plan view. The lift pin 13 is disposed on the outer circumferential portion of the susceptor 11.

Next, a processing sequence of the semiconductor substrate S in the process chamber 2 of the epitaxial growth apparatus will be described.

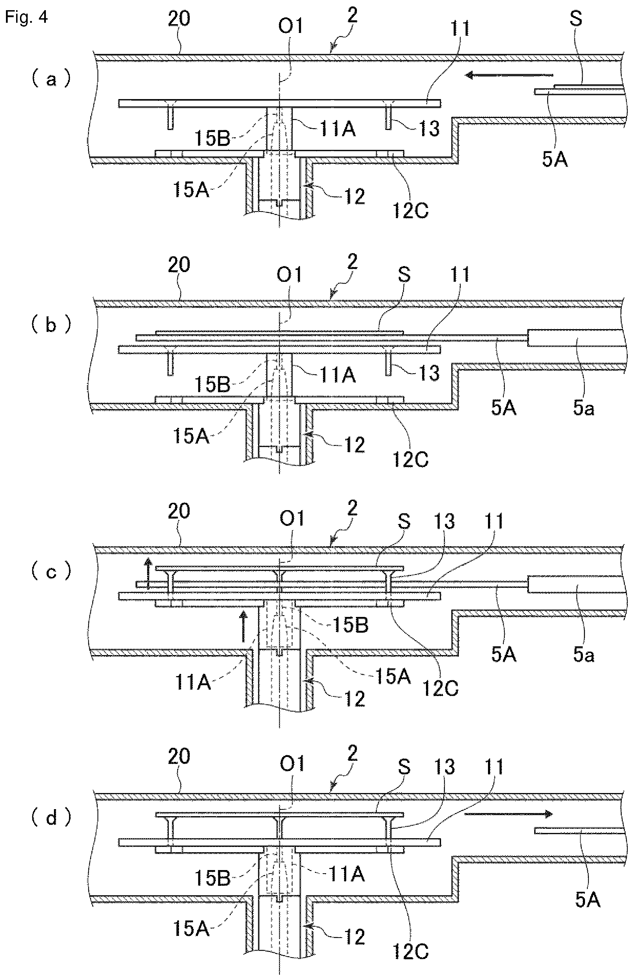

First, a process of conveying the semiconductor substrate S into the process chamber 2 will be described with reference to Fig. 4.

As shown in Fig. 4(a), the blade 5A of the robot arm 5a moves into the process chamber 2 from the conveyance port. Here, the semiconductor substrate S that is reaction-processed thereafter is disposed on the upper surface of the blade 5A. Then, as shown in Fig. 4(b), the semiconductor substrate S is located above the susceptor 11.

Next, as shown in Fig. 4(c), the finger plate wafer lift 12 is raised. Here, when the lift plate 12C abuts the lower end portion of the lift pin 13, the lift pin 13 is lifted.

Accordingly, when the lift pin 13 displaces the semiconductor substrate S upward, a gap in the upward/downward direction is formed between the semiconductor substrate S and the blade 5A.

Then, as shown in Fig. 4(d), the semiconductor substrate S is left in the process chamber 2 while being held on the lift pin 13 by moving the blade 5A toward the conveyance port in the horizontal direction. After that, the blade 5A exits the process chamber 2.

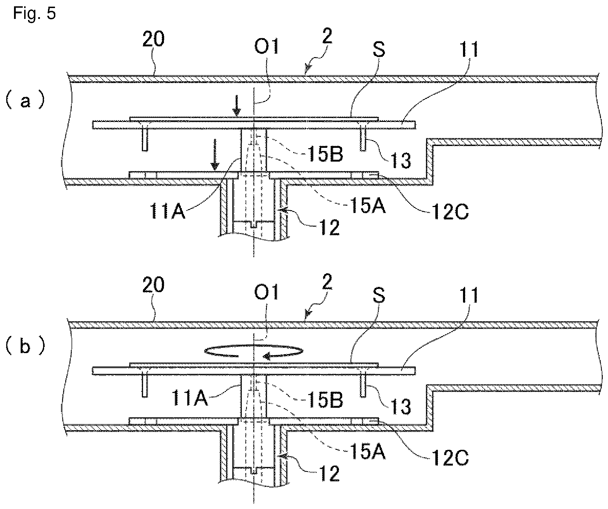

Next, a process of reaction-processing the semiconductor substrate S in the process chamber 2 will be described with reference to Fig. 5.

First, as shown in Fig. 5(a), the lift pin 13 is lowered by lowering the finger plate wafer lift 12. This displaces the semiconductor substrate S held by the lift pin 13 downward to be placed on the upper surface of the susceptor 11.

Here, the finger plate wafer lift 12 lowers a gap in the upward/downward direction between the lift plate 12C and the lift pin 13 as much as possible. Accordingly, during the reaction processing after that, it is possible to minimize transfer of heat of the susceptor 11 and the semiconductor substrate S to the finger plate wafer lift 12.

Then, as shown in Fig. 5(b), heat is applied to the semiconductor substrate S to perform reaction processing. Here, heat is uniformly transferred to the semiconductor substrate S in the circumferential direction by rotating the susceptor 11 in the circumferential direction together with the susceptor shaft 15. This forms a film on the surface of the semiconductor substrate S.

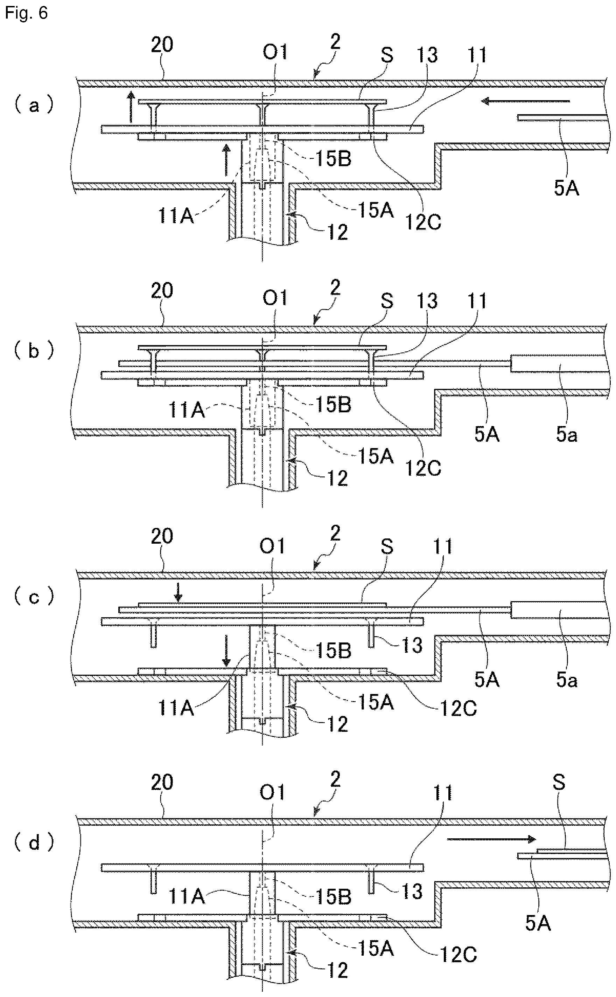

Finally, a process of taking the semiconductor substrate S out of the process chamber 2 will be described with reference to Fig. 6.

First, as shown in Fig. 6(a), the semiconductor substrate S after the reaction processing is displaced upward described as the same as above by raising the finger plate wafer lift 12 while causing the blade 5A to enter the process chamber 2. Then, a gap in the upward/downward direction is formed between the semiconductor substrate S and the susceptor 11.

Next, as shown in Fig. 6(b), the blade 5A is moved toward the susceptor 11 in the horizontal direction and disposed in the gap between the semiconductor substrate S and the susceptor 11.

Then, as shown in Fig. 6(c), the semiconductor substrate S is placed on the upper surface of the blade 5A by lowering the finger plate wafer lift 12.

Finally, the semiconductor substrate S is unloaded from the process chamber 2 by moving the blade 5A toward the conveyance port in the horizontal direction. After that, a post process is performed on the semiconductor substrate S.

As described above, according to the process chamber 2 of the epitaxial growth apparatus of the embodiment, the susceptor 11, only a central portion in the radial direction of which is supported, is provided. Then, the semiconductor substrate S can be displaced upward by raising the lift pin 13 passing through the through-hole 14 of the susceptor 11 without greatly raising the susceptor 11.

For this reason, for example, in comparison with the configuration in which the semiconductor substrate S is greatly displaced upward by raising the susceptor 11, it is possible to reduce the configuration of the portion displaced in the upward/downward direction, and minimize bulkiness of the process chamber 2 in the upward/downward direction.

In addition, since the susceptor shaft 15 that supports the susceptor 11 supports only the central portion of the susceptor 11 in the radial direction, for example, in comparison with the configuration in which the plurality of arm members extending in the radial direction are provided on the upper end portion of the susceptor shaft 15, parts located below the susceptor 11 in the process chamber 2 can be reduced.

Accordingly, when the susceptor 11 is heated by a heat source such as a halogen lamp, for example, from below the process chamber 2, the heat radiated from the heat source can be efficiently transferred to the semiconductor substrate S placed on the susceptor 11 without being blocked by the parts disposed below the susceptor 11.

In addition, since the lift plate 12C located on the tip portion of the support arms 12B has a size greater than that of the portion of the support arms 12B in the circumferential direction except the lift plate 12C, even when the positions of the lift pin 13 and the support arms 12B in the circumferential direction are misaligned slightly, the lift plate 12C can reliably raise the lift pin 13 with respect to the susceptor 11.

In addition, since the through-hole 14 is formed in the outer end portion of the placing surface 11B of the susceptor 11 in the radial direction, the lift pin 13 disposed in the through-hole 14 can be disposed on the outer circumferential portion of the semiconductor substrate S. Accordingly, when the lift pin 13 displaces the semiconductor substrate S upward, the outer circumferential portion of the semiconductor substrate S can be raised, and a posture of the semiconductor substrate S when displaced upward by the lift pin 13 can be stabilized.

Further, the above-mentioned embodiment is merely an example of a typical embodiment of the present invention. Accordingly, various modifications may be performed with respect to the above-mentioned embodiment without departing from the spirit of the present invention.

For example, while the configuration in which the lift plate 12C has a size that is larger than that of the portion of the support arms 12B in the circumferential direction except the lift plate 12C has been shown in the embodiment, it is not limited to the above-mentioned aspect. All the support arms 12B may have a uniform size in the circumferential direction including the tip portion.

In addition, while the configuration in which the through-hole 14 is formed in the outer end portion of the placing surface 11B of the susceptor 11 in the radial direction has been shown in the above-mentioned embodiment, it is not limited to the above-mentioned aspect. The through-hole 14 may be formed in the placing surface 11B on an inner side in the radial direction.

In addition, these variants may be selected and combined as appropriate without being limited to the above-mentioned variants or other modifications may be applied. The invention is defined by the appended claims.

### [Reference Signs List]

1 Semiconductor manufacturing apparatus
2 Process chamber
11 Susceptor
12 Finger plate wafer lift
12A Support pipe
12B Support arm
12C Lift plate (tip portion)
13 Lift pin
14 Through-hole
15 Susceptor shaft (shaft member)
16 Shaft wafer lift
S Semiconductor substrate

## Claims

1. A process chamber (2) of an epitaxial growth apparatus configured to perform reaction processing on a semiconductor substrate (S), the process chamber (2) comprising:
a susceptor (11) supported and disposed in the process chamber (2) by a shaft member (15) supporting only a central portion in a radial direction and extending in an upward/downward direction, and on which the semiconductor substrate (S) is placed;
a finger plate wafer lift (12) disposed below the susceptor (11) and configured to be movable in an axial direction of the shaft member (15); and
a lift pin (13) configured to displace the semiconductor substrate (S) upward from an upper surface of the susceptor (11) according to approach of the finger plate wafer lift (12) to the susceptor (11),
wherein a through-hole (14) through which the lift pin (13) passes is formed in the susceptor (11), and
wherein the finger plate wafer lift (12) comprises:
a support pipe (12A) extending in the upward/downward direction; and
**characterized in that** a plurality of support arms (12B) extending straight in the horizontal direction from an upper end portion of the support pipe (12A) in the radial direction,
wherein a tip portion (12C) facing the lift pin (13) in the upward/downward direction is formed on an outer end portion of the support arm (12B) in the radial direction, and
the tip portion (12C) has a size that is greater than that of a portion of the support arm (12B) in a circumferential direction except the tip portion (12C).

2. The process chamber (2) according to claim 1, wherein the semiconductor substrate (S) is placed on a portion of the upper surface of the susceptor (11) except the outer circumferential edge portion and a placing surface recessed more than the outer circumferential edge portion is formed thereon, and
the through-hole (14) is formed in an outer end portion of the placing surface in the radial direction.

## Patentansprüche

1. Prozesskammer (2) einer epitaktischen Wachstumsvorrichtung, die dazu konfiguriert ist, eine Reaktionsverarbeitung an einem Halbleitersubstrat (S) durchzuführen, wobei die Prozesskammer (2) umfasst:
einen Suszeptor (11), der in der Prozesskammer (2) von einem Schaftelement (15) getragen wird und angeordnet ist, das nur einen zentralen Abschnitt in einer radialen Richtung trägt und sich in einer Aufwärts-/Abwärtsrichtung erstreckt und auf dem das Halbleitersubstrat (S) platziert wird;
eine Fingerplattenwaferhebevorrichtung (12), die unter dem Suszeptor (11) angeordnet ist und dazu konfiguriert ist, in einer Achsrichtung des Schaftelements (15) bewegbar zu sein; und
einen Hebestift (13), der dazu konfiguriert ist, das Halbleitersubstrat (S) nach oben von einer oberen Fläche des Suszeptors (11) entsprechend einer Annäherung der Fingerplattenwaferhebevorrichtung (12) an den Suszeptor (11) zu verlagern,
wobei eine Durchgangsbohrung (14), durch die der Hebestift (13) hindurchtritt, in dem Suszeptor (11) ausgebildet ist, und
wobei die Fingerplattenwaferhebevorrichtung (12) umfasst:
ein Stützrohr (12A), das sich in der Aufwärts-/Abwärtsrichtung erstreckt; und **dadurch gekennzeichnet, dass** sich mehrere Stützarme (12B) gerade in der horizontalen Richtung von einem oberen Endabschnitt des Stützrohrs (12A) in der radialen Richtung erstrecken,
wobei ein Spitzenabschnitt (12C), der dem Hebestift (13) in der Aufwärts-/Abwärtsrichtung zugewandt ist, an einem äußeren Endabschnitt des Stützarms (12B) in der radialen Richtung ausgebildet ist, und
der Spitzenabschnitt (12C) eine Größe aufweist, die größer als die eines Abschnitts des Stützarms (12B) in einer Umfangsrichtung ist, mit Ausnahme des Spitzenabschnitts (12C).

2. Prozesskammer (2) nach Anspruch 1, wobei das Halbleitersubstrat (S) auf einem Abschnitt der oberen Fläche des Suszeptors (11) platziert wird, mit Ausnahme des äußeren Umfangskantenabschnitts, und eine Platzierungsfläche, die tiefer eingelassen ist als der äußere Umfangskantenabschnitt, darauf ausgebildet ist und
die Durchgangsbohrung (14) in einem äußeren Endabschnitt der Platzierungsfläche in der radialen Richtung ausgebildet ist.

## Revendications

1. Chambre de traitement (2) d'un appareil de croissance épitaxiale configuré pour effectuer un traitement de réaction sur un substrat semi-conducteur (S), la chambre de traitement (2) comprenant :
un suscepteur (11) supporté et disposé dans la chambre de traitement (2) au moyen d'un élément d'arbre (15) qui ne supporte qu'une partie centrale dans une direction radiale et qui s'étend dans une direction vers le haut/vers le bas, et sur lequel est placé le substrat semi-conducteur (S) ;
un dispositif de levage de plaquette à plaques en forme de doigts (12) disposé sous le suscepteur (11) et configuré pour être mobile dans une direction axiale de l'élément d'arbre (15) ; et
une broche de levage (13) configurée pour déplacer le substrat semi-conducteur (S) vers le haut à partir d'une surface supérieure du suscepteur (11) en fonction de l'approche du dispositif de levage de plaquette à plaques en forme de doigts (12) vers le suscepteur (11),
dans laquelle un trou traversant (14) à travers lequel passe la broche de levage (13) est formé dans le suscepteur (11), et
dans laquelle le dispositif de levage de plaquette à plaques en forme de doigts (12) comprend :
un tube de support (12A) s'étendant dans la direction vers le haut/vers le bas ; et
**caractérisée en ce qu'**une pluralité de bras de support (12B) s'étendant en ligne droite dans la direction horizontale à partir d'une partie d'extrémité supérieure du tube de support (12A) dans la direction radiale,
dans laquelle une partie d'extrémité (12C) faisant face à la broche de levage (13) dans la direction vers le haut/vers le bas est formée sur une partie d'extrémité extérieure du bras de support (12B) dans la direction radiale, et la partie d'extrémité (12C) a une taille supérieure à celle d'une partie du bras de support (12B) dans une direction circonférentielle à l'exception de la partie d'extrémité (12C).

2. Chambre de traitement (2) selon la revendication 1, dans laquelle le substrat semi-conducteur (S) est placé sur une partie de la surface supérieure du suscepteur (11) à l'exception de la partie périphérique circonférentielle extérieure, et une surface de placement plus en retrait que la partie périphérique circonférentielle extérieure y est formée, et le trou traversant (14) est formé dans une partie d'extrémité extérieure de la surface de placement dans la direction radiale.
